# EUROPÄISCHE PATENTANMELDUNG

(11) **EP 1 091 405 A2**
(43) Veröffentlichungstag der Anmeldung: **11.04.2001**
(21) Anmeldenummer: 00120655.6
(22) Anmeldetag: 21.09.2000
(51) Int. Cl.: H01L 23/525, H01L 23/528

(54) **Anordnung zur Verringerung der Anzahl der Messpads auf einem Halbleiterchip**

(30) Priorität: 28.09.1999 DE 19946495
(71) Anmelder: Infineon Technologies AG, 81669 München (DE)
(72) Erfinder: Feuerle, Robert, 85579 Neubiberg (DE)
(74) Vertreter: MÜLLER & HOFFMANN Patentanwälte

(57) **Zusammenfassung**

Die Erfindung betrifft eine Anordnung zur Verringerung der Anzahl der Pads auf einem eine integrierte Schaltung enthaltenden Halbleiterchip (1). Diese Anordnung umfaßt insbesondere einen Analog/Digital-Wandler (3), der von verschiedenen Stellen (2) in der im Halbleiterchip (1) realisierten integrierten Schaltung gelieferte interne Spannungen über ein Pad (9) einem Fuse-Cutter (5) zuführt, welcher sodann einzelne Fuses (7) schießt, um die gemessenen internen Spannungen an Zielspannungswerte heranzuführen.

## Beschreibung

Die vorliegende Erfindung betrifft eine Anordnung zur Verringerung der Anzahl der Messpads (oder Mess-Kontaktkissen) auf einem eine integrierte Schaltung enthaltenden Halbleiterchip, bei der zur Einstellung interner elektrischer Spannungen in der integrierten Schaltung im Halbleiterchip Fuses zu schießen sind.

Bei einer bestehenden Anordnung werden beim Testen eines Halbleiterchips an zahlreichen Messpads interne Spannungen, die in der im Halbleiterchip realisierten integrierten Schaltung vorliegen, mittels eines Testers abgegriffen, um nach Vergleich dieser internen Spannungen mit gewünschten Werten entsprechende Fuses durch einen Fuse-Cutter (oder ein Fuse-Auslösegerät) zu schießen, wodurch die internen Spannungen auf ihre gewünschten Werte getrimmt werden. Ein üblicher Wert, der durch Schießen einer Fuse erreicht werden kann, ist beispielsweise eine Spannungsabsenkung um 10 mV.

Ein derartiges Vorgehen ermöglicht ohne weiteres eine relativ genaue Einstellung sämtlicher interner Spannungen in der integrierten Schaltung. Es ist aber relativ aufwendig, da jeder einzelnen internen Spannung ein gesondertes, sogenanntes Messpad zugeordnet werden muß, über das der Wert der internen Spannung nach außen und insbesondere an den Fuse-Cutter abgegeben wird. Durch eine große Anzahl von Messpads, die auch als Charakterisierungspads bezeichnet werden, wird zudem Fläche des Halbleiterchips verbraucht, was in zahlreichen Fällen unerwünscht ist. Dabei ist zu bedenken, daß der Halbleiterchip zusätzlich zu den Messpads in der Regel über zahlreiche Eingabe/Ausgabe-(I/O-)Pads verfügt, über die Signale in die integrierte Schaltung eingespeist bzw. von dieser ausgegeben werden. Oft ist es daher auch problematisch, zusätzlich zu einer großen Anzahl von zwingend notwendigen I/O-Pads auch noch Platz für Messpads zur Verfügung zu stellen.

Es ist daher Aufgabe der vorliegenden Erfindung, eine Anordnung zur Verringerung der Anzahl der Messpads auf einem eine integrierte Schaltung enthaltenden Halbleiterchip zu schaffen, bei der auch mit wenigen zur Verfügung stehenden Pads Fuses genau geschossen werden können.

Diese Aufgabe wird bei einer Anordnung der eingangs genannten Art erfindungsgemäß dadurch gelöst, daß ein im Halbleiterchip enthaltener Analog/Digital-Wandler die internen Spannungen digitalisiert und die so erhaltenen Digitalwerte jeder internen Spannung über ein Eingabe/Ausgabe-Pad an einen externen Fuse-Cutter abgibt, der die Fuses im Halbleiterchip schießt.

Die Erfindung beschreitet damit einen von dem bisherigen Stand der Technik vollkommen abweichenden Weg: durch einen zusätzlichen Analog/Digital-Wandler im Halbleiterchip werden die internen Spannungen, die in der integrierten Schaltung einzustellen sind, digitalisiert. Der so erhaltene digitale Datenstrom kann dann über ein ohnehin vorhandenes I/O-Pad, gegebenenfalls auch über mehrere I/O-Pads, nach außen zu dem Fuse-Cutter ausgegeben werden, der dann wieder in den Halbleiterchip eingreift und dort die Fuses so schießt, daß die jeweiligen internen Spannungen ihre gewünschten Werte annehmen. Anstelle einer Vielzahl von gesonderten Messpads wird ein ohnehin vorhandenes I/O-Pad verwendet, um den digitalen Datenstrom vom Analog/Digital-Wandler zum Fuse-Cutter zu führen und sodann das "Fusen" vorzunehmen.

Der Analog/Digital-Wandler kann in dein Halbleiterchip relativ einfach realisiert werden und erfordert jedenfalls weniger Platz bzw. Fläche als eine Vielzahl von Messpads. Mit einem 6-Bit-Analog/Digital-Wandler können beispielsweise sechs Fuses entsprechend geschossen werden.

Durch die Verringerung der Anzahl der Pads ist es auch möglich, mehr Halbleiterchips als bisher parallel zu testen. Außerdem wird der Trimm-Vorgang zum Einstellen der internen Spannungen in der integrierten Schaltung vereinfacht, indem das Messen und Berechnen der internen Zielspannung letztlich auf den Halbleiterchip selbst verlagert wird.

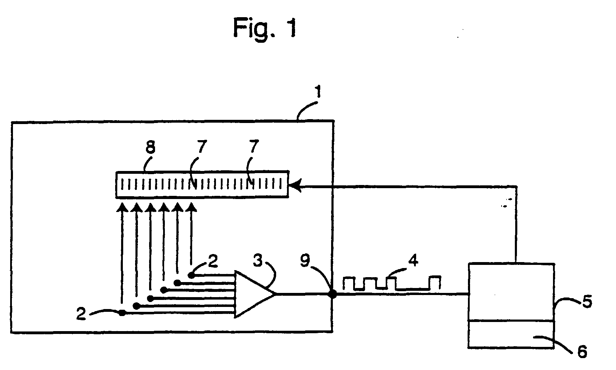

Nachfolgend wird die Erfindung anhand der Zeichnung näher erläutert, in deren einziger Figur die erfindungsgemäße Anordnung schematisch dargestellt ist.

In einem Halbleiterchip 1 ist eine integrierte Schaltung realisiert, bei der an mehreren Stellen 2 eine interne elektrische Spannung gemessen und auf einen jeweils zugeordneten internen Zielspannungswert eingestellt werden soll. Hierzu werden die an den Stellen 2 gemessenen Spannungswerte einem Analog/Digital-(A/D-)Wandler 3 zugeführt, der die einzelnen, an den Stellen 2 gemessenen Spannungswerte digitalisiert und einen digitalen Datenstrom 4 nach außen abgibt. Dieser Datenstrom 4 wird einem Fuse-Cutter 5 zugeführt, der mit einer entsprechenden Recheneinheit 6 versehen ist, die den digitalen Datenstrom 4, der Information über die internen Spannungen an jeder Stelle 2 enthält, mit entsprechenden für diese Stellen 2 vorgesehenen Spannungswerten, sogenannten internen Zielspannungen, vergleicht. Abhängig von dem Vergleichsergebnis werden dann bestimmte Fuses 7 geschossen, die in einem Fusefeld 8 des Halbleiterchips 1 angeordnet sein können und einzelnen Stellen 2 zugewiesen sind. Durch dieses Schießen von Fuses 7 werden die internen Spannungen an den einzelnen Stellen 2 näher an ihre Zielspannungen herangebracht, bis diese schließlich möglichst genau erreicht sind.

Die Erfindung ermöglicht so durch den zusätzlichen Aufwand des Analog/Digital-Wandlers 3 die Einsparung einer großen Anzahl an Messpads, da der Analog/Digital-Wandler 3 mit seinem Ausgang an ein übliches I/O-Pad 9 der in dem Halbleiterchip 1 realisierten integrierten Schaltung angeschlossen werden kann. Gegebenenfalls kann für den Analog/Digital-Wandler 3 ein solcher Wandler verwendet werden, der ohnehin bereits in der integrierten Schaltung des Halbleiterchips 1 enthalten ist. In diesem Fall tritt praktisch kein zusätzlicher Aufwand auf.

## Patentansprüche

1. Anordnung zur Verringerung der Anzahl der Pads auf einem eine integrierte Schaltung enthaltenden Halbleiterchip (1), bei der zur Einstellung interner elektrischer Spannungen in der integrierten Schaltung im Halbleiterchip (1) Fuses (7) zu schießen sind,
**dadurch gekennzeichnet,** daß ein im Halbleiterchip (1) enthaltener Analog/Digital-Wandler (3) die internen Spannungen digitalisiert und die so erhaltenen Digitalwerte jeder internen Spannung über ein Eingabe/Ausgabe-Pad (9) an einen externen Fuse-Cutter (5) abgibt, der die Fuses (7) im Halbleiterchip (1) schießt.

2. Anordnung nach Anspruch 1,
**dadurch gekennzeichnet,** daß dem Analog/Digital-Wandler (3) die internen Spannungen von einer Vielzahl von Stellen (2) in der integrierten Schaltung zuführbar sind.

3. Anordnung nach Anspruch 1 oder 2,
**dadurch gekennzeichnet,** daß der Fuse-Cutter (5) eine Recheneinheit (6) enthält.

4. Anordnung nach Anspruch 3,
**dadurch gekennzeichnet,** daß die Recheneinheit (6) einen Vergleich zwischen gemessenen internen Spannungen und internen Zielspannungen vornimmt.
